# EUROPEAN PATENT APPLICATION

(11) **EP 1 909 319 A1**
(43) Date of publication of application: **09.04.2008**
(21) Application number: 06301010.2
(22) Date of filing: 03.10.2006
(51) Int. Cl.: H01L 21/768

(54) **Low resistance interconnect**

(71) Applicant: STMicroelectronics (Crolles 2) SAS, 38920 Crolles (FR)
(72) Inventor: Torres, Joaquin, 38950, SAINT MARTIN LE VINOUX (FR); Farcy, Alexis, 73490, LA RAVOIRE (FR)
(74) Representative: de Beaumont, Michel

(57) **Abstract**

The invention concerns a method of forming an interconnect passing through an insulating layer in an integrated circuit, the method including the steps of forming a hole through the insulating layer; filling the hole with silicon; depositing a layer of metal covering one end of the hole; and performing heating such that the silicon in said hole reacts with the metal layer to form a metal compound throughout the depth of said hole.

## Description

### FIELD OF THE INVENTION

The present invention relates to a low resistance interconnect, and in particular a low resistance interconnect formed in a semiconductor device.

### BACKGROUND OF THE INVENTION

Interconnects in integrated circuits are often formed of tungsten. The use of tungsten has a number of particular drawbacks, which become more apparent as the aspect ratio of the interconnect increases. For example, tungsten has a relatively high resistance, in a range of 50 to 500 n.Ohm.m. Furthermore, tungsten does not adhere well to silicon dioxide, which is typically the material used for forming the insulating layer of such devices, and therefore layers of titanium and titanium nitride are generally provided, and the interfaces between these layers add further resistance to the interconnect. Additionally, as the diameter of the interconnect hole reduces in diameter, it becomes difficult to provide a good tungsten deposition throughout the whole depth of the hole, and thus there is a high risk of voids forming which add to the resistance of the interconnect, or prevent an electrical connection altogether. Due to the additional titanium and titanium nitride layers, the hole to be filled with tungsten is even further reduced in diameter, adding to this problem.

It has been proposed to use copper as an alternative to tungsten for forming the interconnect, due to its lower resistance. However, copper has many of the same drawbacks as tungsten. In particular, for the formation of a copper interconnect, metal barriers are used to prevent copper diffusion, and as with tungsten, the interfaces between these layers add significantly to the resistance of the interconnect. These layers also significantly reduce the diameter of the interconnect hole, making it very hard to deposit copper evenly throughout.

### SUMMARY OF THE INVENTION

It is one aim of the present invention to at least partially address one or more of the drawbacks described above.

According to a first aspect of the present invention there is provided a method of forming an interconnect passing through an insulating layer in an integrated circuit, the method comprising forming a hole through the insulating layer; filling the hole with silicon; depositing a layer of metal covering one end of the hole; and performing heating such that the silicon in the hole reacts with the metal layer to form a metal compound, such as a metal silicide, throughout the depth of the hole.

According to one embodiment of the present invenion the hole has an aspect ratio greater than 1 and in an alternative embodiment the hole has an aspect ratio greater than 3.

According to a further embodiment of the present invention the silicon is amorphous silicon, or alternatively polysilicon.

According to yet a further embodiment of the present invention, the method further comprises removing unreacted metal from the metal layer using a selective chemical etch.

According to a further embodiment of the present invention, the step of filling the hole with silicon comprises the steps of depositing a layer of silicon over the insulating layer, the silicon filling the hole, and removing excess silicon outside the hole on the surface of the insulating layer.

According to a further aspect of the present invention, there is provided an integrated circuit comprising at least one interconnect formed through a layer of insulating material and arranged to make an electrical connection, said interconnect being formed of a metal silicon compound and having an aspect ratio greater that 1.

According to one embodiment of the present invention, the interconnect has an aspect ration greater than 3 and a diameter of less than 50 nm, and the insulating layer has a thickness greater than 50 nm.

According to one embodiment of the present invention, the interconnect is arranged to make contact with a contact layer also formed of a metal silicon compound.

According to a further embodiment of the present invention, the metal silicide of said interconnect comprises at least one of titanium silicide; nickel silicide; and cobalt silicide.

### BRIEF DESCRIPTION OF THE DRAWINGS

The foregoing and other purposes, features, aspects and advantages of the invention will become apparent from the following detailed description of embodiments, given by way of illustration and not limitation with reference to the accompanying drawings.
Figure 1 illustrates a tungsten interconnect; and
Figures 2A to 2F are cross-section views of successive steps in the formation of an interconnect according to an embodiment of the present invention.

As is normal in the field of integrated circuits, the figures have not been drawn to scale.

### DETAILED DESCRIPTION OF THE INVENTION

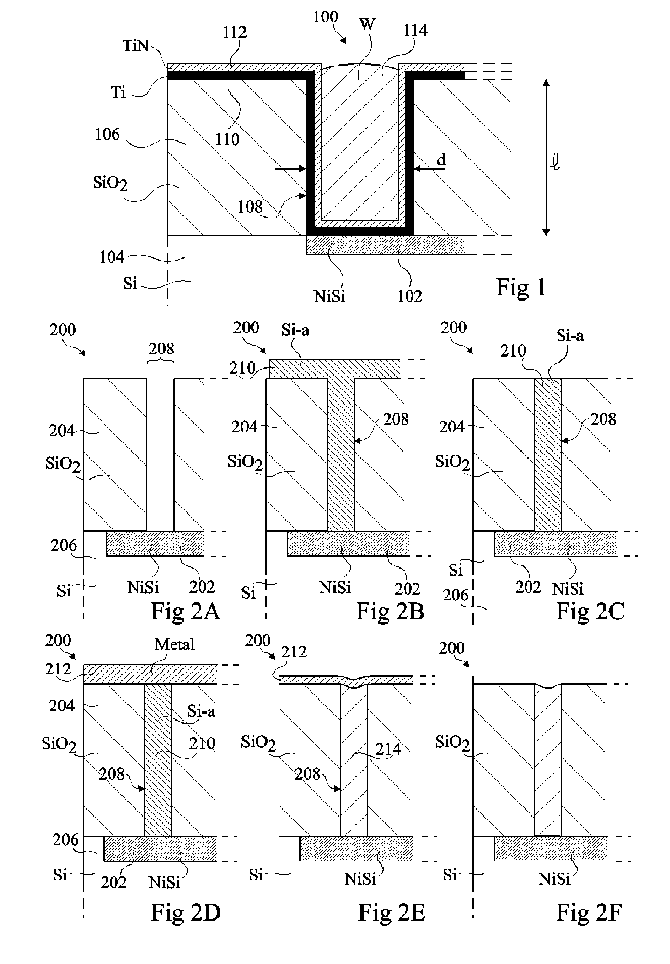

Figure 1 is a cross-section view illustrating a typical interconnect 100 formed of tungsten. A nickel silicide (NiSi) layer 102, which for example provides the gate, source or drain contact of a MOS (metal oxide semiconductor) transistor, is provided on a silicon substrate 104, the top surface of nickel silicide layer 102 being level with the top surface of silicon layer 104. A silicon dioxide layer 106 covers the silicon substrate 104 and nickel silicide layer 102. To form the interconnect 100, a hole 108, aligned with the nickel silicide layer 102, has been etched through the silicon dioxide layer 106 to expose the top surface of nickel silicide layer 102. A titanium layer 110 has then been deposited, covering the silicon dioxide layer 102, and lining hole 108. A further layer 112 of titanium nitride has then been deposited over the titanium layer 110, again lining hole 108. Finally a tungsten layer 114 has been deposited, filling the trench, and forming the connection. Although not shown, CMP (chemical mechanical polishing) can be used to remove unwanted metal layers formed outside hole 108.

Hole 108 for example has a diameter d of 100 nm. As new silicon technologies are developed, there is a need for interconnects to be formed in smaller holes, with high aspect ratios. The aspect ratio is the ratio between the depth (labelled "1" in Figure 1) of the hole, equal in this case to roughly the thickness of the silicon dioxide layer 106, and the diameter (labelled "d" in Figure 1) of the hole. The higher the aspect ratio, the harder it is to form a good interconnect in the hole, and the higher the resistance of the interconnect. It is very important that the interconnect has a low resistance. For example, the interconnects connected to the source and drain terminals of a MOS transistor add to the overall transistor resistance, and therefore the resistance of this interconnect should be minimized.

Figures 2A to 2F are cross-section views illustrating steps in an exemplary method according to one embodiment of the present invention for forming an interconnect in a silicon structure 200 for making a connection with a conducting layer 202, through an insulating layer 204 formed for example of silicon dioxide (SiO₂).

With reference to Figure 2A, conducting layer 202 is shown which in this example is formed of nickel silicide (NiSi) and for example forms the gate, source or drain electrode of a MOS transistor. Such metal silicide conducting layers are often provided in MOS transistors as part of the gate, source or drain terminals to provide a good contact surface with which a connection can be made. Conducting layer 202 is for example provided over a silicon substrate 206. Insulating layer 204 is formed over the silicon substrate 206 and conducting layer 202. A hole 208, aligned with the conducting layer 204, is etched through the silicon dioxide layer, exposing an area on the surface of the conducting layer 202.

Figure 2B illustrates a subsequent step in which a layer 210 of amorphous silicon (Si-a) is deposited over the silicon structure, for example by chemical vapour deposition (CVD), covering the silicon dioxide layer 204, and filling the hole 208 down to the conducting layer 202. In alternative embodiments, polysilicon could be used instead of amorphous silicon.

Figure 2C illustrates a next step in which chemical mechanical polishing or a chemical mechanical etch is performed to remove amorphous silicon deposited outside hole 208. Alternatively any silicon etch-back process can be used to remove unwanted silicon. After this step, the amorphous silicon 210 deposited in hole 208 remains.

Figure 2D illustrates a subsequent step in which a metal layer 212 is deposited over the silicon structure covering the top surface of silicon dioxide layer 204, and also covering the top surface of the amorphous silicon 210 in hole 208. Metal layer 212 for example comprises one of titanium, cobalt, or nickel, however other metals are also possible.

Figure 2E illustrates a subsequent step in which a metal silicide 214 is formed in hole 208. This can be achieved by heating the silicon structure, for example in an oven, to an appropriate temperature T to cause a reaction between metal layer 212 and the amorphous silicon 210 in hole 208. Temperature T will depend on certain variables, such as the particular metal forming metal layer 212, the dimensions of the hole etc. Assuming that the metal is titanium, and the hole is for example 40 nm in diameter, a temperature as low as approximately 400 degrees would be sufficient. The resulting metal silicide 214 replaces amorphous silicon 210 in hole 208. As illustrated, the volume of metal silicide 214 is slightly less than the volume of amorphous silicon that it replaces, and therefore there is a slight dip in the top surface of the metal silicide 214.

Figure 2F illustrates a subsequent step in which remaining unreacted metal from layer 212 is removed, for example using a selective chemical etch.

Thus an interconnect has been formed that comprises metal silicon compound, such as metal silicide. Metal silicides are generally known to have a low resistance. For example, titanium silicide or nickel silicide can have a resistance of between 15 and 20 n.Ohm.m. Furthermore, electro-migration of the metal silicide will be low compared to copper for example, as the silicon substrate of the device provides a very high source of silicon particles to replace migrating silicon particles.

According to a one advantage of embodiments of the present invention, the metal silicide 214 of the interconnect adheres well to the silicon dioxide layer 204 and the conducting layer 202, and therefore no additional layers are provided in the hole 208 for helping adhesion. Likewise, no metal barrier layers are provided to prevent diffusion. By avoiding the use of such additional layers, there is no additional resistance caused by the interface between such layers, and thus a low contact resistance interconnect can be achieved. Furthermore, the metal silicide 214 fills the whole of the diameter of the hole 204, increasing the diameter of the interconnect, and reducing its resistance when compared to an interconnect core material formed in only part of the hole. The resistance at the interface between the metal silicide 214 in the hole 208 and the conducting layer 202 will also be very low, both being formed for example of metal silicides. Furthermore, in some embodiments the metal silicide 214 and the conducting layer 202 can be formed of the same metal silicide, for example nickel silicide or titanium silicide.

The metal silicide interconnect 214 can be formed having a relatively high aspect ratio, for example an aspect ratio between 1 and 30. In particular, an aspect ration greater than 3 is achievable. The metal silicide interconnect can be formed in a hole 208 having a diameter of less than 50 nm, for example of 30 or 40 nm. The depth of the hole 208 is determined by the thickness of the insulating layer 204 that it traverses, both of which can have a value of more than 50 nm, and for example between 150 and 300 nm.

According to a further advantage of embodiments of the present invention, the method described above allows CMP steps to be avoided, CMP being difficult and time consuming to perform. In particular, excess amorphous silicon from layer 210 deposited in the step of Figure 2B can be removed using an etch-back process. Furthermore, the formation of the metal silicide 214 advantageously results in a metal silicide having a volume of more than 90 percent of the amorphous silicon 210 in hole 208, and thus no CMP is required before a further connection can be made with the interconnect. Unreacted metal from metal layer 212 can be removed using a selective chemical etch, which removes the metal without removing the silicon dioxide of layer 206 nor the metal silicide 214.

An interconnect is for example any conductive track formed passing through at least part of an insulating layer in an integrated circuit device, and connected to contacts at both ends so that the interconnect can conduct a current between the contacts and thus provide an electrical connection. The contacts are for example any conducting material provided for interfacing with the interconnect, such as the gate, source or drain electrode of a MOSFET, the electrode of a capacitor etc.

Having thus described at least one illustrative embodiment of the invention, various alterations, modifications and improvements will readily occur to those skilled in the art. Such alterations, modifications and improvements are intended to be within the scope of the invention.

For example, the metal of layer 212 used for forming the metal silicide could be one of a number of suitable metals, for example metals such as titanium, nickel and cobalt could be used. Whilst the example of a nickel silicide conducting layer 202 has been described, this layer could be formed of an alternative metal silicide or conducting material. Furthermore, the insulating layer 204 could be formed of any suitable insulating material, and alternative examples includes silicon based material such as SiLK (silicon low k).

It will be apparent to those skilled in the art that the interconnect described herein and method of forming the same could be used in any number of different applications in integrated circuits or silicon devices where a connection is required to pass through an insulating layer, for example for forming vias, forming connections to capacitor electrodes, forming connections with the terminals of transistors etc.

## Claims

1. A method of forming an interconnect passing through an insulating layer (204) in an integrated circuit, said method comprising:
forming a hole (208) through said insulating layer;
filling said hole with silicon (210);
depositing a layer of metal (212) covering one end of said hole; and
performing heating such that said silicon in said hole reacts with said metal layer to form a metal compound (214) throughout the depth of said hole.

2. The method of claim 1, wherein said hole has an aspect ratio greater than 1.

3. The method of claim 1 or 2, wherein said silicon is amorphous silicon.

4. The method of any preceding claim, further comprising removing unreacted metal from said metal layer using a selective chemical etch.

5. The method of claim 1, wherein said step of filling said hole with silicon comprises the steps of depositing a layer of silicon (210) over said insulating layer, said silicon filling said hole, and then removing excess silicon outside said hole on the surface of said insulating layer.

6. An integrated circuit comprising at least one interconnect formed through a layer of insulating material (204) and arranged to make an electrical connection, said interconnect being formed of a metal silicon compound (214) and having an aspect ratio greater than 1.

7. The integrated circuit of claim 6, wherein said interconnect has an aspect ration greater than 3 and a diameter of less than 50 nm.

8. The integrated circuit of claim 6, wherein said insulating layer has a thickness greater than 50 nm.

9. The integrated circuit of any of claims 6 to 8, wherein said interconnect is arranged to make contact with a contact layer (202) also formed of a metal silicon compound.

10. The integrated circuit of any of claims 6 to 9, wherein the metal silicide of said interconnect comprises at least one of:
titanium silicide;
nickel silicide; and
cobalt silicide.
